(19) Europäisches Patentamt
European Patent Office
Office européen des brevets

(11) **EP 4 553 926 A1**

(12) **EUROPEAN PATENT APPLICATION**
published in accordance with Art. 153(4) EPC

(43) Date of publication:
**14.05.2025 Bulletin 2025/20**

(21) Application number: **24732381.9**

(22) Date of filing: **28.04.2024**

(51) International Patent Classification (IPC):
*H01M 4/505* $^{(2010.01)}$          *H01M 4/04* $^{(2006.01)}$
*H01M 10/0525* $^{(2010.01)}$

(52) Cooperative Patent Classification (CPC):
Y02E 60/10

(86) International application number:
**PCT/CN2024/090293**

(87) International publication number:
**WO 2025/066131 (03.04.2025 Gazette 2025/14)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **28.09.2023 CN 202311290065**

(71) Applicant: **BTR NANO TECH CO., LTD.**
**Shenzhen, Guangdong 518106 (CN)**

(72) Inventors:
• **LIU, Guoxue**
**Shenzhen, Guangdong 518106 (CN)**

• **XIE, Qian**
**Shenzhen, Guangdong 518106 (CN)**
• **ZHENG, Yu**
**Shenzhen, Guangdong 518106 (CN)**
• **WU, Xiaozhen**
**Shenzhen, Guangdong 518106 (CN)**
• **YANG, Shunyi**
**Shenzhen, Guangdong 518106 (CN)**
• **HUANG, Youyuan**
**Shenzhen, Guangdong 518106 (CN)**

(74) Representative: **Barker Brettell LLP**
**100 Hagley Road**
**Edgbaston**
**Birmingham B16 8QQ (GB)**

(54) **POSITIVE ELECTRODE MATERIAL, PREPARATION METHOD THEREFOR AND BATTERY**

(57)    The present disclosure provides cathode material, preparation method therefor and battery. The cathode material is a monocrystalline cathode material. The cathode material has a chemical formula of $Li_aNi_{x-}M_yN_zO_2$, where $0.98 \leq a \leq 1.05$, $0.60 \leq x < 1$, $0 < y \leq 0.40$, $0 \leq z < 0.1$, $x+y+z=1$, M is selected from at least one of Co, Mn and Al, and N is a doping metal; a distribution curve of particles with a particle size ranging from 1 μm to 4 μm has a peak consistent with distribution of a Pulse function, and a particle size distribution width of the particles with the particle size ranging from 1 μm to 4 μm is Span (a) and satisfies that $0.8 <$ Span (a) $< 1.6$; and in a particle size quantity distribution diagram of the cathode material, a distribution curve of particles with a particle size ranging from 0.1 μm to 1 μm and excluding 1 μm has a peak consistent with distribution of a Voigt function, and a particle size distribution width of the particles with the particle size ranging from 0.1 μm to 1 μm and excluding 1 μm is Span (b) and satisfies that $0.4 <$ Span (b) $< 0.8$. The cathode material of the present disclosure can have high compaction density and strong structural stability and cycle stability, so that the cathode material can achieve higher capacity and rate performance.

Fig. 1

subject a mixed salt solution to spray drying by a spray pyrolysis method to obtain a precursor, where the mixed salt solution includes a nickel source and an M source, a pressure-diameter ratio of a nozzle is controlled at 3.5 MPa/mm-40 MPa/mm in a spray drying process, and M is selected from at least one of Co, Mn and Al — S10

subject a mixture of the precursor and a lithium source to primary sintering treatment to obtain a cathode material — S20

EP 4 553 926 A1

**Description**

**Cross-Reference to Related Application**

The present application claims the priority of a Chinese patent application No. 202311290065.X, filed to China National Intellectual Property Administration on September 28, 2023, with the title of "CATHODE MATERIAL, PREPARATION METHOD THEREFOR AND BATTERY", the entire contents of which are incorporated herein by reference.

**Technical Field**

The present disclosure belongs to the technical field of cathode materials, and particularly relates to cathode material, preparation method therefor and battery.

**Background**

Lithium-ion batteries have been widely used in notebook computers, mobile phones, digital products and other fields due to high energy density, good safety performance, long cycle life and environmental friendliness. The development of cathode materials is relatively slow compared with the development of high-capacity anode materials (about 800 mAh/g-1,000 mAh/g). Therefore, the development of high-capacity and high-voltage cathode materials to improve the energy density of the lithium-ion batteries has been concerned by researchers at present.

Commonly used ternary cathode materials with layered structures have the characteristics of high capacity, high voltage, good cycle life, good safety performance and the like, and have become main cathode materials for the development of power batteries. However, with increase of the content of nickel in the ternary cathode materials, problems such as lithium-nickel mixed arrangement, structural degradation, reduced thermal stability and residual alkali increase are inevitably caused, leading to battery capacity degradation, cycle reduction and poor structural stability, thus affecting use with safety and high performance.

At present, the particle size distribution width can be increased by a pulverizing method to improve the compaction density of electrode plates, but this method can only improve the compaction density of the electrode plates and cannot comprehensively improve the structural stability and cycle stability of the cathode materials.

Therefore, how to make the cathode materials achieve high compaction density and further improve the structural stability and cycle stability of the materials is currently required.

**SUMMARY**

The purpose of the present disclosure is to provide a cathode material, a preparation method therefor and a lithium-ion battery. The cathode material of the present disclosure can have high compaction density and strong structural stability and cycle stability, so that the cathode material can achieve higher capacity and rate performance.

In a first aspect, the present disclosure provides a cathode material. The cathode material has a chemical formula of $Li_aNi_xM_yN_zO_2$, where $0.98 \leq a \leq 1.05$, $0.60 \leq x < 1$, $0 < y \leq 0.40$, $0 \leq z < 0.1$, $x+y+z=1$, M is selected from at least one of Co, Mn and Al, and N is a doping metal;

in a particle size quantity distribution diagram of the cathode material, a distribution curve of particles with a particle size ranging from 1 $\mu$m to 4 $\mu$m has a peak consistent with distribution of a Pulse function, and a particle size distribution width of the particles with the particle size ranging from 1 $\mu$m to 4 $\mu$m is Span (a) and satisfies that $0.8 < $ Span (a) $< 1.6$;

and in the particle size quantity distribution diagram of the cathode material, a distribution curve of particles with a particle size ranging from 0.1 $\mu$m to 1 $\mu$m and excluding 1 $\mu$m has a peak consistent with distribution of a Voigt function, and a particle size distribution width of the particles with the particle size ranging from 0.1 $\mu$m to 1 $\mu$m and excluding 1 $\mu$m is Span (b) and satisfies that $0.4 < $ Span (b) $< 0.8$.

In some embodiments, the cathode material includes single grains with a same orientation, where an average particle size of the single grains is 1 $\mu$m-5 $\mu$m.

In some embodiments, a mass content of the element N in the cathode material is 500 ppm-10,000 ppm; and/or, the N is selected from at least one of Ti, Zr, Mg, Ca, Sr, Ba, Nb, Ta, Sb, Sn, Wand Y.

In some embodiments, particle size volume distribution of the cathode material satisfies that $D_{min} > 0.1$ $\mu$m, $2.5$ pm $< D_{50} < 5.5$ $\mu$m, and $D_{max} < 14$ $\mu$m.

In some embodiments, a particle size volume distribution width of the cathode material satisfies that

$1.2 \leq (D_{90}-D_{10})/D_{50}$, $D_{10} \leq 1.8$ μm, and $D_{90} \geq 5.5$ μm.

In some embodiments, in the particle size quantity distribution diagram of the cathode material, the cathode material has at least two particle size distribution peaks.

In some embodiments, in an X-ray diffraction (XRD) pattern of the cathode material, a characteristic peak corresponding to a crystal face (003) has a peak intensity of $I_{003}$, a characteristic peak corresponding to a crystal face (104) of the cathode material has a peak intensity of $I_{104}$, and $I_{003}/I_{104}$ is 1.2-1.6.

In some embodiments, the cathode material has a specific surface area of 0.6 m$^2$/g-1.5 m$^2$/g.

In some embodiments, the cathode material has a Quantachrome tap density of equal to or greater than 1.8 g/cm$^3$.

In some embodiments, the cathode material has a compaction density of equal to or greater than 3.2 g/cm$^3$.

In some embodiments, the cathode material has a bulk density of equal to or greater than 1.2 g/cm$^3$.

In a second aspect, the present disclosure provides a preparation method for a cathode material. The preparation method includes the following steps:

subjecting a mixed salt solution to spray drying by a spray pyrolysis method to obtain a precursor, where the mixed salt solution includes a nickel source and an M source, a pressure-diameter ratio of a nozzle is controlled at 3.5 MPa/mm-40 MPa/mm in a spray drying process, and the M is selected from at least one of Co, Mn and Al;

and subjecting a mixture of the precursor and a lithium source to primary sintering treatment to obtain a cathode material.

In some embodiments, the precursor has a chemical formula of $Ni_xM_yO_2$, where $0.60 \leq x < 1$ and $0 < y \leq 0.40$.

In some embodiments, the nickel source includes at least one of nickel nitrate, nickel acetate, nickel chloride and nickel sulfate.

In some embodiments, the M source includes at least one of M nitrate, M acetate, M chloride and M sulfate.

In some embodiments, an internal temperature of a reaction chamber is 550 °C-1,050 °C in the spray drying process.

In some embodiments, the mixed salt solution has a concentration of 0.5 mol/L-4 mol/L.

In some embodiments, the lithium source includes at least one of lithium hydroxide, lithium carbonate, lithium nitrate, lithium acetate, lithium sulfate and lithium oxalate.

In some embodiments, addition amounts of the lithium source and the precursor satisfy that a ratio of a molar amount of Li to a total molar amount of metals in the precursor is (1.01-1.1):1.

In some embodiments, the primary sintering treatment is carried out in an oxygen-containing atmosphere, and the oxygen-containing atmosphere has an oxygen content of equal to or greater than 95%.

In some embodiments, the primary sintering treatment is carried out at a temperature of 600 °C-1,000°C.

In some embodiments, the primary sintering treatment is carried out for 6 h-16 h.

In some embodiments, the method further includes: mixing a primary sintering product with a dopant containing a metal N, and carrying out secondary sintering treatment to obtain a secondary sintering product, where the secondary sintering treatment is carried out at a temperature of 600 °C-1,000 °C, the secondary sintering treatment is carried out for 6 h-16 h, and/or, the N is selected from at least one of Ti, Zr, Mg, Ca, Sr, Ba, Nb, Ta, Sb, Sn, W and Y.

In some embodiments, the method further includes: carrying out a reaction between the primary sintering product or the secondary sintering product and boric acid to obtain a cathode material, where calculated with a mass of the cathode material as 100%, an addition amount of the boric acid is 500 ppm-2,000 ppm.

In a third aspect, the present disclosure provides a battery. The battery includes a cathode material.

The present disclosure at least has the following beneficial effects.

According to the cathode material provided in the present disclosure, by controlling the particle size distribution width of the particles with the particle size ranging from 1 μm to 4 μm in the particle size quantity distribution diagram as Span (a) and the particle size distribution width of the particles with the particle size ranging from 0.1 μm to 1 μm and excluding 1 μm in the particle size quantity distribution diagram as Span (b), the compaction density of the material can be effectively improved, and the packing density of the particles is increased. The cathode material can be understood as a particle powder. The particle powder usually has different degrees of energy on the surface and inside or between particles and other places, which may lead to an entire particle particle system staying in an unstable energy state, resulting in aggregation, polarization or trace chemical reactions and other impacts. Thus, technical persons have difficulty in obtaining the cathode material with expected particle distribution in an actual operation process. Therefore, in order to maintain the entire particle particle system at a relative balance, the particle size distribution curves of the particles are controlled to be consistent with the Pulse function and the Voigt function in the present disclosure, so that energy of the particle system is relatively stable, regulation and control of the Span (a) and the Span (b) are further achieved, and self-mixing is achieved by adopting a closest packing mode of a monodisperse system of the two particles, namely multistage dispersed particles, to improve the packing density. The distribution curve of the particles with the particle size ranging from 0.1 μm to 1 μm and excluding 1 μm has a peak consistent with distribution of the Voigt function. The Voigt function is composed of two independent functions (namely introduced by a Lorentz function and a Gaussian function), which can comprehensively control the stability of the particle system from different dimensions and achieve multistage self-filling of the particles more easily, further forming an ideal closest packing mode. In addition, the particles of the cathode material of the present disclosure have more stable physical and chemical properties and better particle strength, can provide better cycle stability and safety performance for lithium-ion batteries, and can also significantly reduce cracking of particles in a pressing process of an electrode plate and improve the compaction density and volume energy density of the electrode plate.

According to the preparation method for a cathode material provided in the present disclosure, by adopting a spray drying process and controlling the pressure-diameter ratio of a nozzle at 3.5 MPa/mm-40 MPa/mm, the formation of particles has continuity in the spray drying process, and the particle size of the precursor is in a multistage dispersed state, so that the particle size quantity distribution diagram of the prepared cathode material has a multi-peak distribution curve. The particles of the cathode material of the present disclosure have more stable physical and chemical properties and better particle strength, can provide better cycle stability and safety performance for lithium-ion batteries, and can also significantly reduce cracking of particles in a pressing process of an electrode plate and improve the compaction density and volume energy density of the electrode plate.

## Brief Description of the Drawings

In order to illustrate technical solutions in embodiments of the present disclosure or in the prior art more clearly, drawings required to be used in description of the embodiments or the prior art are briefly introduced below. Obviously, the drawings described below are merely some embodiments of the present disclosure, and for persons of ordinary skill in the art, other drawings can also be obtained without exerting creative effort according to these drawings.

Fig. 1 is a flow chart of a preparation method for a cathode material provided in an embodiment of the present disclosure.

Fig. 2 shows a first peak in a particle size quantity distribution diagram of a cathode material provided in Embodiment 1 of the present disclosure.

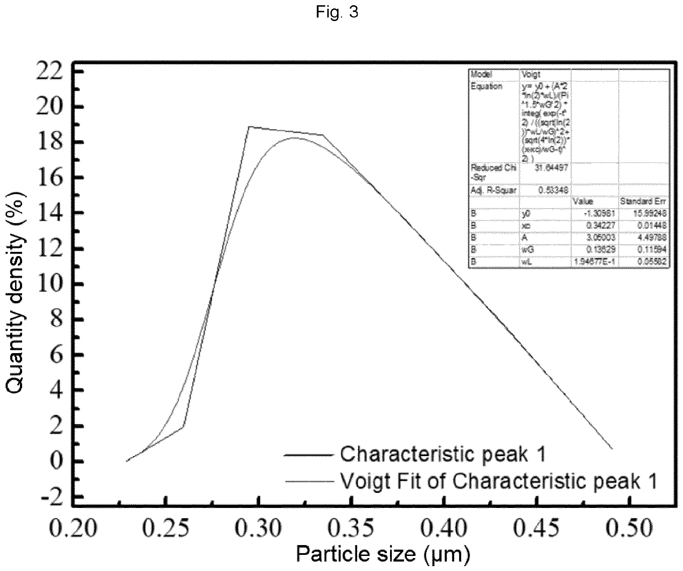

Fig. 3 shows a second peak in the particle size quantity distribution diagram of the cathode material provided in Embodiment 1 of the present disclosure.

Fig. 4 is the particle size quantity distribution diagram of the cathode material provided in Embodiment 1 of the present disclosure.

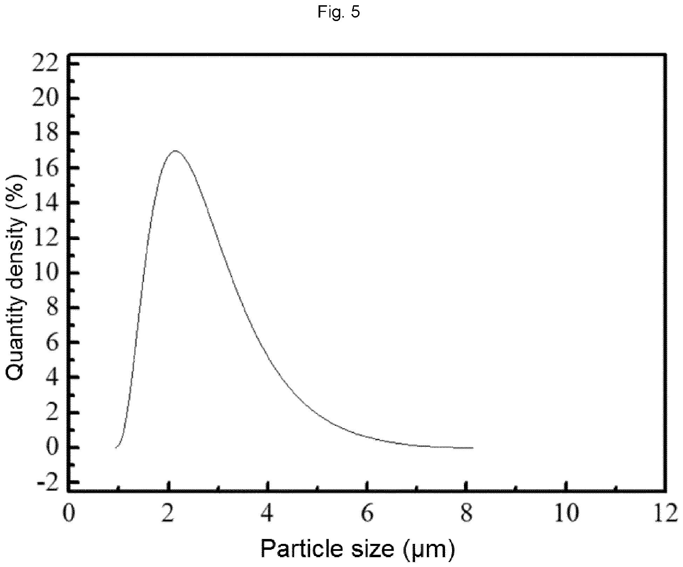

Fig. 5 is a particle size quantity distribution diagram of a cathode material provided in Comparative Embodiment 1 of the present disclosure.

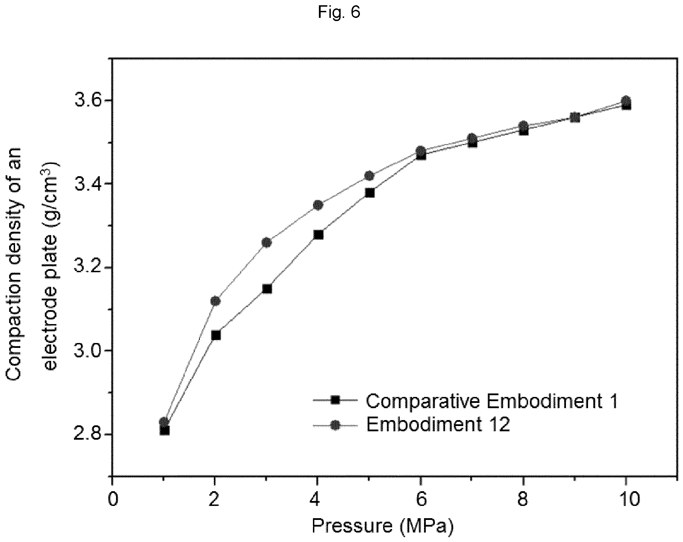

Fig. 6 is a comparison diagram of compaction density curves of the cathode materials provided in Embodiment 1 and Comparative Embodiment 1 of the present disclosure.

## Detailed Description of the Embodiments

In order to make the technical solutions of the present disclosure better understood, the embodiments of the present disclosure are described in detail below in combination with the attached drawings.

Obviously, the embodiments described are merely a part of the embodiments of the present disclosure, rather than all of the embodiments. Based on the embodiments described in this disclosure, all other implementations obtained by ordinary technicians in the field without creative effort are also within the scope of protection of this disclosure.

In addition, the terms "first" and "second" are used merely for the purpose of description and shall not be construed as indicating or implying relative importance or implying a quantity of indicated technical features. Therefore, the features restricted by the "first" or "second" may explicitly indicate or implicitly include at least one of the features.

In order to make the present disclosure easily understood, specific terms are properly defined in the present disclosure. Unless otherwise defined herein, all technical terms and scientific terms used in the present disclosure have meanings as those generally understood by persons skilled in the field to which the present disclosure belongs.

As used herein, the term "matrix" refers to a lithium type composite oxide synthesized by a high-temperature solid phase reaction after a precursor and a lithium salt are mixed, and includes lithium and metal elements.

As used herein, the term "primary particles" refer to particles formed separately without aggregates.

As used herein, the term "secondary particles" refer to particles formed by agglomeration of the primary particles.

At present, the particle size distribution width can be increased by a pulverizing method to improve the compaction density of electrode plates, but this method can only improve the compaction density of the electrode plates and cannot comprehensively improve the structural stability and cycle stability of cathode materials. How to make the cathode materials achieve high compaction density and further improve the structural stability and cycle stability of the materials is currently required.

The present disclosure provides a cathode material. The cathode material has a chemical formula of $Li_aNi_{x-}M_yN_zO_2$, where $0.98 \leq a \leq 1.05$, $0.60 \leq x < 1$, $0 < y \leq 0.40$, $0 \leq z < 0.1$, $x+y+z=1$, M is selected from at least one of Co, Mn and Al, and N is a doping metal;

in a particle size quantity distribution diagram of the cathode material, a distribution curve of particles with a particle size ranging from 1 $\mu$m to 4 $\mu$m has a peak consistent with distribution of a Pulse function, and a particle size distribution width of the particles with the particle size ranging from 1 $\mu$m to 4 $\mu$m is Span (a) and satisfies that $0.8<$Span (a) $<1.6$;

and in the particle size quantity distribution diagram of the cathode material, a distribution curve of particles with a particle size ranging from 0.1 $\mu$m to 1 $\mu$m and excluding 1 $\mu$m has a peak consistent with distribution of a Voigt function, and a particle size distribution width of the particles with the particle size ranging from 0.1 $\mu$m to 1 $\mu$m and excluding 1 $\mu$m is Span (b) and satisfies that $0.4<$Span (b) $<0.8$.

In the above solutions, by controlling the particle size distribution width of the particles ranging from 1 $\mu$m to 4 $\mu$m in the particle size quantity distribution diagram as Span (a) and the particle size distribution width of the particles ranging from 0.1 $\mu$m to 1 $\mu$m and excluding 1 $\mu$m in the particle size quantity distribution diagram as Span (b), the compaction density of the material can be effectively improved, and the packing density of the particles is increased. Since the cathode material has multiple peaks in the quantity distribution diagram and different peaks have distribution morphology of the Pulse function and distribution morphology of the Voigt function respectively, particle size distribution of the single crystal particles is not simple filling of small and large particles, but can achieve a closest packing mode of a monodisperse system of the particles, then multistage dispersed mixing of the particles is achieved, and gaps between the particles can always be filled with particles of suitable sizes to a maximum extent. For example, when smaller particles are filled between larger particles, gaps are still found between the larger particles and the smaller particles. When the above particle distribution is satisfied, the situation can still be realized that the gaps between the larger particles and the smaller particles can be filled with particles of suitable sizes, so that maximum cycle filling and accumulation of the particles of different particle sizes are achieved to improve the packing density. In addition, the cathode material of the present disclosure can provide better cycle stability and safety performance for lithium-ion batteries, and can also significantly reduce cracking of particles in a pressing process of an electrode plate and improve the compaction density and volume energy density of the electrode plate.

In the present disclosure, in the particle size quantity distribution diagram of the cathode material, the distribution curve of the particles with the particle size ranging from 1 $\mu$m to 4 $\mu$m has a peak consistent with distribution of the Pulse function, and the particle size distribution width of the particles with the particle size ranging from 1 $\mu$m to 4 $\mu$m is Span (a) and satisfies that $0.8<$Span (a)$<1.6$; and the Span (a) may be specifically 0.81, 0.85, 0.89, 0.92, 0.98, 1.01, 1.05, 1.2, 1.25, 1.3, 1.39, 1.4, 1.42, 1.45, 1.5 or 1.59 and the like, which is not limited herein. Preferably, the Span (a) satisfies that $0.8<$Span (a) $<1.4$.

That is to say, the peak ranging from 1 $\mu$m to 4 $\mu$m in the quantity distribution diagram is consistent with half-normal distribution of the Pulse function. Specifically, the Pulse function is shown in Formula (1):

$$P(x) = y_0 + A(1 - e^{-\frac{x-x_0}{t_1}})^p e^{-\frac{x-x_0}{t_2}} \quad (1)$$

where $x_0$ and $y_0$ are addition correction coefficients of x and P(x), respectively, $t_1$ and $t_2$ are multiplication correction coefficients of x, A is a multiplicative correction coefficient of y, and p is an exponential coefficient.

In the present disclosure, in the particle size quantity distribution diagram of the cathode material, the distribution curve of the particles with the particle size ranging from 0.1 $\mu$m to 1 $\mu$m and excluding 1 $\mu$m has a peak consistent with distribution of the Voigt function, and the particle size distribution width of the particles with the particle size ranging from 0.1 $\mu$m to 1 $\mu$m and excluding 1 $\mu$m is Span (b) and satisfies that $0.4<$Span (b) $<0.8$. The Span (b) may be specifically 0.41, 0.42, 0.45, 0.58, 0.62, 0.7, 0.72, 0.75 or 0.795 and the like, which is not limited herein.

That is to say, the peak ranging from 0.1 $\mu$m to 1 $\mu$m and excluding 1 $\mu$m in the quantity distribution diagram is consistent with distribution of the Voigt function, and the peak consistent with distribution of the Voigt function has a higher height than the peak consistent with the Pulse function. Specifically, the Voigt function is shown in Formula (2):

$$V(x) = \frac{1}{\sqrt{4\pi t}} \int_{-\infty}^{\infty} \int_{-\infty}^{\infty} \frac{\exp\left(-\frac{(x-y)^2}{4t}\right)}{1+y^2} dy \frac{\exp\left(-\frac{(x-y)^2}{4t}\right)}{1+y^2} dy \quad (2)$$

in Formula (2), t is a peak pattern coefficient, and a smaller t value means a sharper peak and a smaller half-peak width, indicating that small particles have a large quantity and good monodispersity and can be better filled to gaps of large particles to improve the packing density of the cathode material.

Therefore, the cathode material of the present disclosure has at least two characteristic peaks, and distribution of the two peaks is consistent with the above rule.

In some embodiments, in the particle size quantity distribution diagram of the cathode material, the cathode material has at least two particle size distribution peaks.

In some embodiments, the cathode material includes single grains with a same orientation, where an average particle size of the single grains is 1 $\mu$m-5 $\mu$m. The particles of the cathode material of the present disclosure include 1 $\mu$m-5 $\mu$m particles as single grains with a same orientation, which can further stabilize distribution of a cathode particle system to achieve full self-filling and can also prevent the appearance of cracks caused by extrusion of the particles and other reasons after the particles reach closest packing, where the 1 $\mu$m-5 $\mu$m particles with the same orientation can make the cathode particles achieve a further stable structure, more uniform bulk phase component distribution and better particle strength, can significantly reduce cracking of particles in a pressing process of an electrode plate and improve the compaction density and volume energy density of the electrode plate.

It should be noted that the grain orientation of the cathode material can at least be measured by electron back scatter diffraction (EBSD). Ten single grains with a same orientation are randomly selected, the particle size of each grain is measured, and an arithmetic average value is calculated to serve as an average particle size of the single grains.

It is to be understood that the single grains in the present disclosure may be single particles composed of one primary particle, or secondary particles formed by agglomeration of several primary particles. The "primary particles" refer to a smallest particle unit identified when the active cathode material is observed by a scanning electron microscope, and the "secondary particles" refer to a secondary structure formed by agglomeration of multiple primary particles.

In some embodiments, a particle size volume distribution width of the cathode material satisfies that 1.2 $\leq$ $D_{90}$-$D_{10}$)/$D_{50}$, where the ($D_{90}$-$D_{10}$)/$D_{50}$ may be specifically 1.2, 1.3, 1.4, 1.5, 1.6, 1.7 or 1.8 and the like and certainly may also be other values in the above range, which is not limited herein. It should be noted that the particle size volume distribution width of the cathode material is measured based on all particles herein, and that is to say, the particle size volume distribution is calculated from negative infinity to positive infinity based on all particles.

In some embodiments, the N is selected from at least one of Ti, Zr, Mg, Ca, Sr, Ba, Nb, Ta, Sb, Sn, W and Y.

In some embodiments, a mass content of the element N in the cathode material is 500 ppm-10,000 ppm, may be specifically 500 ppm, 1,000 ppm, 1,500 ppm, 2,500 ppm, 5,000 ppm, 7,000 ppm, 8,000 ppm or 10,000 ppm and certainly may also be other values in the above range, which is not limited herein. The N in the above range can improve a crystal structure of a monocrystalline material and control an optimal orientation of crystal growth.

In some embodiments, in the particle size quantity distribution diagram of the cathode material, the particle size distribution curve of the particles with the particle size ranging from 1 $\mu$m to 4 $\mu$m satisfies that 1 $\mu$m$\leq$$D_{50}$$\leq$4 $\mu$m, and the $D_{50}$ may be specifically 1 $\mu$m, 1.5 $\mu$m, 1.8 $\mu$m, 2.0 $\mu$m, 2.5 $\mu$m, 2.8 $\mu$m, 3.5 $\mu$m or 4 $\mu$m and the like and certainly may also be other values in the above range, which is not limited herein. When the particle size of the particles ranging from 1 $\mu$m to 4 $\mu$m satisfies the above range, convenience is provided for increasing the compaction density and comprehensively improving the electrochemical performance of the cathode material.

In some embodiments, in the particle size quantity distribution diagram of the cathode material, the particle size distribution curve of the particles with the particle size ranging from 0.1 $\mu$m to 1 $\mu$m satisfies that 0.1 $\mu$m$\leq$$D_{50}$$\leq$1 $\mu$m, and the $D_{50}$ may be specifically 0.1 $\mu$m, 0.2 $\mu$m, 0.5 $\mu$m, 0.6 $\mu$m, 0.7 $\mu$m, 0.8 $\mu$m, 0.9 $\mu$m or 0.99 $\mu$m and the like and certainly may also be other values in the above range, which is not limited herein. When the particle size of the particles ranging from 0.1 $\mu$m to 1 $\mu$m satisfies the above range, convenience is provided for increasing the compaction density and comprehensively improving the electrochemical performance of the cathode material.

In some embodiments, in the particle size quantity distribution diagram of the cathode material, a peak value of the distribution curve of the particles with the particle size ranging from 0.1 $\mu$m to 1 $\mu$m is equal to or greater than 15%, may be specifically 15%, 16%, 17%, 18%, 19%, 20% or 25% and the like and certainly may also be other values in the above range, which is not limited herein.

In some embodiments, the particle size volume distribution of the cathode material satisfies that $D_{min}$>0.1 $\mu$m, 2.5 $\mu$m<$D_{50}$<5.5 $\mu$m, $D_{max}$<14 $\mu$m; and the $D_{min}$ may be specifically 0.11 $\mu$m, 0.12 $\mu$m, 0.15 $\mu$m, 0.2 $\mu$m, 0.5 $\mu$m, 0.8 $\mu$m, 0.9 $\mu$m or 0.99 $\mu$m and the like and certainly may also be other values in the above range, which is not limited herein.

In some embodiments, the particle size volume distribution of the cathode material satisfies that $2.5\ \mu m < D_{50} < 5.5\ \mu m$, and the $D_{50}$ may be specifically $2.51\ \mu m$, $2.8\ \mu m$, $3.0\ \mu m$, $3.2\ \mu m$, $3.5\ \mu m$, $3.8\ \mu m$, $4.2\ \mu m$, $4.5\ \mu m$, $4.8\ \mu m$ or $5.5\ \mu m$ and the like and certainly may also be other values in the above range, which is not limited herein.

In some embodiments, the particle size volume distribution of the cathode material satisfies that $D_{max} < 14\ \mu m$, and the $D_{max}$ may be specifically $13.9\ \mu m$, $12\ \mu m$, $11\ \mu m$, $8\ \mu m$, $5\ \mu m$ or $4.99\ \mu m$ and the like and certainly may also be other values in the above range, which is not limited herein.

In some embodiments, a particle size $D_{10}$ of the cathode material is equal to or less than $1.8\ \mu m$, may be specifically $1.0\ \mu m$, $1.1\ \mu m$, $1.2\ \mu m$, $1.3\ \mu m$, $1.4\ \mu m$, $1.5\ \mu m$, $1.6\ \mu m$, $1.7\ \mu m$ or $1.8\ \mu m$ and the like and certainly may also be other values in the above range, which is not limited herein. A particle size $D_{90}$ of the cathode material is equal to or greater than $5.5\ \mu m$, may be specifically $5.5\ \mu m$, $5.8\ \mu m$, $6.2\ \mu m$, $6.3\ \mu m$, $6.4\ \mu m$, $6.5\ \mu m$, $6.6\ \mu m$, $7.0\ \mu m$ or $8.0\ \mu m$ and the like and certainly may also be other values in the above range, which is not limited herein. When the particle size of the cathode material is controlled in the above range, especially the smaller $D_{10}$ and the larger $D_{90}$, it is indicated that the cathode material has wider particle size distribution, which is conducive to increasing a gram capacity of the cathode material. It should be noted that the cathode material herein is obtained by measuring the particle size volume distribution based on all particles, and that is to say, the particle size volume distribution is calculated from negative infinity to positive infinity based on all particles.

In some embodiments, in an XRD pattern of the cathode material, a characteristic peak corresponding to a crystal face (003) has a peak intensity of $I_{003}$, a characteristic peak corresponding to a crystal face (104) of the cathode material has a peak intensity of $I_{104}$, and $I_{003}/I_{104}$ is 1.2-1.6 and may be specifically 1.2, 1.25, 1.3, 1.35, 1.4, 1.45, 1.5, 1.55 or 1.6 and the like, which is not limited herein. The $I_{003}/I_{104}$ in the above range can achieve single crystal particles with round morphology, thereby increasing the accumulation vacancy of small particles and further improving the compaction density.

In some embodiments, a specific surface area of the cathode material is $0.6\ m^2/g$-$1.5\ m^2/g$, may be specifically $0.6\ m^2/g$, $0.7\ m^2/g$, $0.9\ m^2/g$, $1.0\ m^2/g$, $1.1\ m^2/g$, $1.2\ m^2/g$, $1.3\ m^2/g$, $1.4\ m^2/g$ or $1.5\ m^2/g$ and the like and certainly may also be other values in the above range, which is not limited herein.

In some embodiments, a Quantachrome tap density of the cathode material is equal to or greater than $1.8\ g/cm^3$, may be specifically $1.8\ g/cm^3$, $1.9\ g/cm^3$, $2.0\ g/cm^3$, $2.1\ g/cm^3$, $2.2\ g/cm^3$ and the like and certainly may also be other values in the above range, which is not limited herein. The Quantachrome tap density of the cathode material is controlled in the above range, which is conducive to improving the energy density of an electrode plate.

In some embodiments, a compaction density of the cathode material is equal to or greater than $3.2\ g/cm^3$, may be specifically $3.2\ g/cm^3$, $3.6\ g/cm^3$, $3.8\ g/cm^3$, $4.0\ g/cm^3$, $4.2\ g/cm^3$ and the like and certainly may also be other values in the above range, which is not limited herein.

In some embodiments, a bulk density of the cathode material is equal to or greater than $1.2\ g/cm^3$, may be specifically $1.2\ g/cm^3$, $1.3\ g/cm^3$, $1.4\ g/cm^3$, $1.5\ g/cm^3$, $1.6\ g/cm^3$ and the like and certainly may also be other values in the above range, which is not limited herein. A higher bulk density is conducive to material transportation and storage.

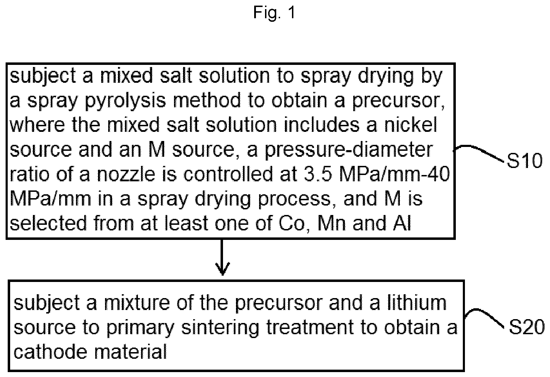

In a second aspect, the present disclosure provides a preparation method for a cathode material. As shown in Fig. 1, the preparation method for a cathode material includes the following steps:

> S10: subjecting a mixed salt solution to spray drying by a spray pyrolysis method to obtain a precursor, where the mixed salt solution includes a nickel source and an M source, a pressure-diameter ratio of a nozzle is controlled at 3.5 MPa/mm-40 MPa/mm in a spray drying process, and the M is selected from at least one of Co, Mn and Al;

> S20: subjecting a mixture of the precursor and a lithium source to primary sintering treatment to obtain a cathode material.

According to the preparation method for a cathode material provided in the present disclosure, by adopting a spray drying process and controlling the pressure-diameter ratio of a nozzle at 3.5 MPa/mm-40 MPa/mm, the formation of particles has continuity in the spray drying process, and the particle size of the precursor is in a multistage dispersed state, so that the particle size quantity distribution diagram of the prepared cathode material has a multi-peak distribution curve. The particles of the cathode material of the present disclosure have more stable physical and chemical properties and better particle strength, can provide better cycle stability and safety performance for lithium-ion batteries, and can also significantly reduce cracking of particles in a pressing process of an electrode plate and improve the compaction density and volume energy density of the electrode plate.

The preparation method of the present disclosure is specifically introduced in combination with embodiments below.

S10. A mixed salt solution containing a nickel source and an M source is prepared, and the mixed salt solution is subjected to spray drying by a spray pyrolysis method to obtain a precursor.

In some embodiments, the precursor has a chemical formula of $Ni_xM_yO$, where $0.60 \leq x < 1$, $0 < y \leq 0.40$ and $x+y=1$. That is to say, appropriate amounts of the nickel source and the M source are weighed according to the chemical formula of the precursor, respectively. The M source may be at least one of a cobalt source, a manganese source and an aluminum source.

In some embodiments, the precursor has a chemical formula of $Ni_x(CoMn)_y(OH)_2$, which is a precursor of a nickel-cobalt-manganese ternary material.

In some embodiments, the nickel source includes at least one of nickel nitrate, nickel acetate, nickel chloride and nickel sulfate. Preferably, the nickel source includes nickel chloride.

In some embodiments, the M source includes at least one of M nitrate, M acetate, M chloride and M sulfate. Preferably, the M source includes M chloride.

In some embodiments, an internal temperature of a reaction chamber is 550 °C-1,050 °C in the spray drying process. The temperature may be specifically 550 °C, 600 °C, 650°C, 700 °C, 750 °C, 800 °C, 900 °C, 1,000 °C or 1,050 °C and may also be other values in the above range, which is not limited herein. Preferably, the internal temperature of the reaction chamber is 850 °C-1,000 °C.

In some embodiments, a concentration of the mixed salt solution is 0.5 mol/L-4 mol/L and may be specifically 0.5 mol/L, 1.0 mol/L, 1.5 mol/L, 2.0 mol/L, 2.5 mol/L, 3.0 mol/L, 3.5 mol/L or 4.0 mol/L and the like, which is not limited herein.

S20. A mixture of the precursor and a lithium source is subjected to primary sintering treatment to obtain a cathode material.

In some embodiments, the lithium source includes at least one of lithium hydroxide, lithium carbonate, lithium nitrate, lithium acetate, lithium sulfate and lithium oxalate.

In some embodiments, addition amounts of the lithium source and the precursor satisfy that a ratio of a molar amount of Li to a total molar amount of metals in the precursor is (1.01-1.1):1, may be specifically 1.01:1, 1.02:1, 1.05:1, 1.08:1, 1.09:1 or 1.1:1 and the like and certainly may also be other values in the above range, which is not limited herein. In the above range, not only can a mixed arrangement degree of Li/Ni cations be reduced, but also excessive residual lithium on a surface of a sintered material can be reduced and prevented from affecting the processing performance and safety performance.

In some embodiments, the primary sintering treatment is carried out in an oxygen-containing atmosphere, and the oxygen-containing atmosphere has an oxygen content of equal to or greater than 95%. The oxygen-containing atmosphere may be air or a mixed gas of air and oxygen.

In some embodiments, the primary sintering treatment is carried out at a temperature of 600°C-1,000 °C. The temperature may be specifically 600 °C, 700 °C, 750 °C, 800 °C, 900 °C, 950 °C or 1,000 °C and the like, but it is not limited to the listed values, and other unlisted values in the numerical range are also applicable. In the above range, sufficient air can promote oxidation of bivalent nickel to trivalent nickel, reduce mixed arrangement of Li/Ni cations and increase the capacity of the cathode material. Meanwhile, the temperature range is conducive to the formation of a layered structure without leading to material decomposition.

In some embodiments, the primary sintering treatment is carried out for 6 h-16 h. The time may be specifically 6 h, 8 h, 9 h, 10 h, 12 h, 14 h, 15 h or 16 h and the like and certainly may also be other values in the above range, which is not limited herein.

In some embodiments, the method further includes: mixing a primary sintering product with a dopant containing a metal N, and carrying out secondary sintering treatment to obtain a secondary sintering product.

In some embodiments, the N is selected from at least one of Ti, Zr, Mg, Sr, Ba, Nb, W and Y.

In some embodiments, the dopant containing a metal N includes at least one of $Ta_2O_5$, $Sb_2O_5$, $SnO_2$, $Nb_2O_5$, $Nb_2O_3$, BaO, CaO, $Ca(OH)_2$, $Mg(OH)_2$, MgO, $Sr(OH)_2$, SrO, $TiO_2$, $ZrO_2$, $Zr(OH)_4$, $WO_3$ and $Y_2O_3$.

In some embodiments, calculated with a mass of the final product, namely the cathode material, as 100%, a mass content of the element N in the cathode material is 500 ppm-10,000 ppm, may be specifically 500 ppm, 1,000 ppm, 1,500 ppm, 2,500 ppm, 5,000 ppm, 7,000 ppm, 8,000 ppm or 10,000 ppm and certainly may also be other values in the above range, which is not limited herein.

Further, in order to make the dopant better enter a lattice of the cathode material, the secondary sintering treatment is carried out at a temperature of 600 °C-1,000 °C. The temperature may be specifically 600 °C, 700 °C, 750 °C, 800 °C, 900 °C, 950 °C or 1,000 °C and the like, but it is not limited to the listed values, and other unlisted values in the numerical range are also applicable.

In some embodiments, the secondary sintering treatment is carried out for 6 h-16 h. The time may be specifically 6 h, 8 h, 9 h, 10 h, 12 h, 14 h, 15 h or 16 h and the like and certainly may also be other values in the above range, which is not limited herein.

In some embodiments, a solid phase mixing method may include dry grinding, ball milling and the like, which is not limited herein, as long as components are evenly mixed.

In some embodiments, a mixing device may include at least one of a ball mill, a three-dimensional mixer, a high-speed mixer and a VC mixer.

In some embodiments, the secondary sintering treatment is carried out in an oxygen-containing atmosphere. The oxygen-containing atmosphere may be air or a mixed gas of air and oxygen.

Further, the method further includes:
carrying out a reaction between the primary sintering product or the secondary sintering product and boric acid to obtain a cathode material.

In some embodiments, an addition amount of the boric acid is 500 ppm-2,000 ppm and may be specifically 500 ppm, 600 ppm, 800 ppm, 1,000 ppm, 1,300 ppm, 1,500 ppm, 1,800 ppm or 2,000 ppm and the like, which is not limited herein. By carrying out coating treatment with the boric acid, residual alkali on a surface of the cathode material can be effectively neutralized, the content of alkali content on the surface of the cathode material is reduced, and a surface structure of the cathode material is improved.

It should be noted that since parameters of spray drying can be controlled in the preparation method, the particle size of the precursor can be controlled, and pulverizing treatment on the cathode material is not required.

The cathode material prepared by the preparation method of the present disclosure includes single grains with a same orientation, where an average particle size of the single grains is $1\mu m$-$5\ \mu m$, and the average particle size of the single grains may be specifically $1\ \mu m$, $1.5\ \mu m$, $2\ \mu m$, $2.5\ \mu m$, $3\ \mu m$, $3.5\ \mu m$, $4\ \mu m$, $5\ \mu m$ and the like and certainly may also be other values in the above range, which is not limited herein. Compared with polycrystals, single crystals have more stable physical and chemical properties and better particle strength, can provide better cycle stability and safety performance for lithium-ion batteries, and can also significantly reduce cracking of particles in a pressing process of an electrode plate and improve the compaction density and volume energy density of the electrode plate.

In a third aspect, the present disclosure provides a battery. The battery includes a cathode plate, and the cathode plate includes the cathode material or the cathode material prepared by the preparation method.

In some embodiments, the cathode plate further includes a conductive agent, and the conductive agent includes one of conductive carbon black, Ketjen black, graphite and acetylene black.

In some embodiments, the cathode plate further includes a binder, and the binder includes one of sodium carboxymethyl cellulose, cyclodextrin and polyvinylidene fluoride.

The description above shows only preferred embodiments of the present disclosure and is not intended to limit the present disclosure. Any modifications, equivalent substitutions, improvements and the like made within the spirit and principles of the present disclosure shall be included in the scope of protection of the present disclosure.

The embodiments of the present disclosure are further descried in detailed below through several embodiments. The embodiments of the present disclosure are not intended to limit the following specific embodiments. The embodiments may be appropriately changed without deviating from the scope of principal rights.

Test methods are as follows.

(1) The particle size quantity distribution of the cathode material is characterized by adopting Mastersizers 3000, and a specific method is as follows.

A particle size test method for particles is used with reference to GB/T 19077-2016. Determination can be carried out conveniently by using a laser particle size analyzer, such as a Mastersizer 3000 laser particle size analyzer from Malvern Instruments Co. Ltd.

In the particle size quantity distribution diagram of the cathode material, the particle size distribution width functions, namely *Span*(*a*) and *Span*(*b*), of two peaks are expressed as follows:

$$Span(a) = \frac{D90_{p1} - D10_{p1}}{D50_{p1}} \ (3)$$

$D90_{p1,}$ $D10_{p1}$, and $D50_{p1}$ are particle size proportion parameters of the peak with x ranging from 1 $\mu m$ to 4 $\mu m$, respectively;

$$Span(b) = \frac{D90_{p2} - D10_{p2}}{D50_{p2}} \ (4)$$

and $D90_{p2}$, $D10_{p2}$ and $D50_{p2}$ are particle size quantity proportion parameters of the peak with x ranging from 0.1 $\mu m$ to 1 $\mu m$, respectively.

(2) A test method of the specific surface area of the precursor of the cathode material is as follows.

The specific surface area of the cathode material is tested by adopting a Micromeritics Tristar 3020 type specific surface area and pore size analyzer. A certain mass of a powder is weighed and completely degassed under vacuum heating. After a surface adsorbent is removed, the specific surface area of particles is calculated by using a nitrogen adsorption method based on a nitrogen adsorption amount in the unit of $m^2/g$.

(3) The Quantachrome tap density of the cathode material is tested.

An American Quantachrome tap density tester (model: DAT-4-220) is used, and steps are as follows.

1. A measuring cylinder is cleaned and then weighed to obtain a mass as m1.

2. About 50 g of a sample is added to the measuring cylinder, a surface of the sample is placed level as much as possible, and a surrounding area is wiped with paper towels.

3. The sample and the measuring cylinder are weighed to obtain a total mass as m2.

4. The measuring cylinder is placed on a vibration table and then fixed with three symmetrical fixing feet.

5. The tester is turned on and set at a vibration frequency of 5,000 times. A vibration switch is turned on, and the tester automatically stops after vibration to a specified time.

6. The measuring cylinder is taken out, and a volume of the sample is read. When the surface of the sample is level after vibration, the volume is read directly. When the surface is in a slant state, an average value (V) of reading numbers of a highest point and a lowest point is calculated, and the tap density is expressed as (m2-m1)/V.

(4) The compaction density of the cathode material is tested.

The compaction density of the cathode material is tested by adopting American carver 4350, and steps are as follows. 1 g of a sample is placed in a mold and pressed under a pressure of 3 T for 30 s. After the pressing is completed, the height is tested, and the compaction density is calculated.

(5) The bulk density of the cathode material is tested.

The compaction density of the cathode material is tested by adopting a bulk density tester BT101, and steps are as follows. An appropriate amount of a sample is selected, naturally flows into a cloth box, then alternately passes through four glass plates with an inclination angle of 25° and a square funnel in the cloth box and then flows into a cylindrical cup with a known volume (25 mL). Finally, a powder in the cylindrical cup is weighed to obtain a mass.

(6) An XRD test of the cathode material is as follows.

The cathode material is characterized by adopting an XRD instrument (RIGAICU UITIMAIV) to obtain a diffraction intensity $I_{003}$ of a crystal face (003) of the cathode material and a diffraction intensity $I_{104}$ of a crystal face (104), and then $I_{003}/I_{104}$ is calculated.

(7) The electrochemical performance is tested.

The cathode material, conductive carbon and polyvinylidene fluoride are dispersed in N-methylpyrrolidone at a mass ratio of 93:5:2 to prepare cathode slurry with a solid content of 50%. Then, the cathode slurry is coated on aluminum foil and dried to serve as a cathode plate, and a button battery is assembled by using a lithium sheet as an anode plate and sodium hexafluorophosphate-diethylene glycol dimethyl ether (with a $NaPF_6$ concentration of 1 mol/L) as an electrolyte.

An electricity deduction test is as follows.

After standing for 12 h, the battery is tested according to the following rules: charging at 0.1 C and discharging at 0.1 C for 2 cycles (initial efficiency) to reach a constant voltage cut-off current of 0.005 C; charging at 0.5 C and discharging at 0.5 C for 1 cycle (C-rate) to reach a constant voltage cut-off current of 0.05 C; charging at 0.5 C and discharging at 1 C for 1 cycle (C-rate) to reach a constant voltage cut-off current of 0.05 C; charging at 0.5 C and discharging at 2 C for 1 cycle (C-rate) to reach a constant voltage cut-off current of 0.05 C; and charging at 0.5 C and discharging at 1 C for 50 cycles (cycles).

(8) A fitting method for a particle size quantity distribution curve is as follows.

Data of a particle size quantity distribution curve of the cathode material measured by a laser particle size analyzer are obtained. The data with the abscissa ranging from 1 μm to 4 μm are intercepted, the data ranging from 1 μm to 4 μm are introduced into Origin, and a Pulse function is released for fitting. When a chi-square value of a computer fitting degree is equal to or less than 10 ($x^2 \leq 10$), it is indicated that the distribution curve of the particles with the particle size ranging from 1 μm to 4 μm has a peak consistent with distribution of a Pulse function. The data with the abscissa ranging from 0.1 μm to 1 μm (excluding 1 μm) are intercepted and introduced into Origin, and a Voigt function is released for fitting. When an $x^2$ value of a computer fitting degree is equal to or less than 10, it is indicated that the distribution curve of the particles with the particle size ranging from 0.1 μm to 1 μm (excluding 1 μm) has a peak consistent with distribution of a Voigt function.

(9) The particle size volume distribution of the cathode material is characterized by adopting Mastersizers 3000, and a specific method is as follows.

A particle size test method for particles is used with reference to GB/T 19077-2016. Determination can be carried out conveniently by using a laser particle size analyzer, such as a Mastersizer 3000 laser particle size analyzer from Malvern Instruments Co. Ltd., which is used to determine a particle size volume distribution curve of particles of the cathode material.

(10) An electron back scatter diffraction (EBSD) test is as follows.

A sample of the cathode material is first embedded in a carbon paint (PELCO) graphite block, and then a cross-section of the block is polished with an argon ion beam. Electron back scatter diffraction (EBSD) imaging is carried out by using JEOL JSM-7000F scanning electron microscopy. A step size of an EBSD image is set as 250 nm (250 nm×250 nm for each pixel).

Embodiment **1**

(1) Appropriate amounts of nickel chloride, cobalt chloride and manganese chloride were weighed, a precursor $Ni_{0.6}C0_{0.1}Mn_{0.3}O$ was obtained by a spray pyrolysis method, and a pressure-diameter ratio of a nozzle was controlled at 3.5 MPa/mm.

(2) 1 kg of the precursor and 503.6 g of lithium carbonate were weighed, evenly mixed and then subjected to primary sintering treatment at 900 °C for 8 h in an oxygen atmosphere to obtain a primary sintering product.

(3) 300 g of a matrix material and 10 g of zirconia were weighed, evenly mixed, subjected to secondary sintering treatment at 800°C for 5 h in an atmosphere furnace and then cooled to room temperature to obtain a secondary sintering product.

(4) After the above material was fully dispersed by a stirrer, 200 g of the secondary sintering product and 2 g of boric acid were mixed, transferred to an atmosphere furnace and subjected to heat treatment at 550 °C for 5 h. Then, a final product $LiNi_{0.6}Co_{0.09}Mn_{0.3}Zr_{0.01}O_2$ was obtained.

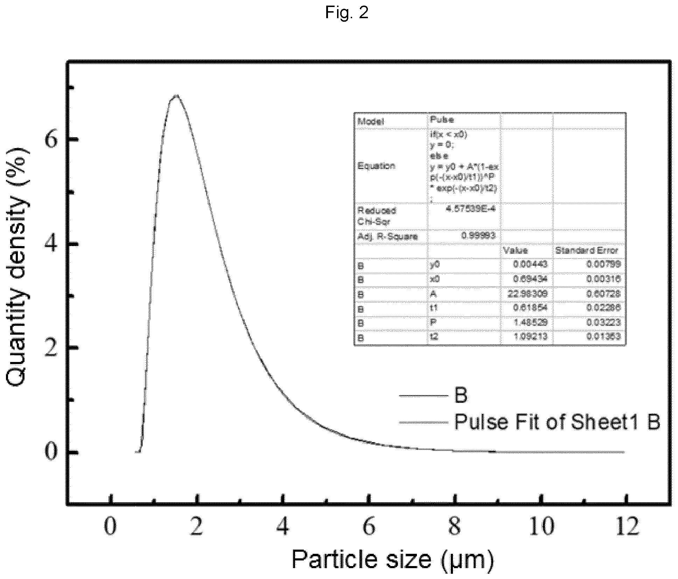

Fig. 2 shows a particle size distribution curve of the cathode material in Embodiment 1, which has two-peak distribution characteristics. A first sharp and high peak represents distribution of particles with the particle size ranging from 0.1 μm to 1 μm and excluding 1 μm, the distribution curve has a peak consistent with distribution of the Voigt function, and these particles have a particle size $D_{50}$ of about 0.5 μm.

A second smooth peak represents distribution of larger particles, the distribution curve of the particles with the particle size ranging from 1 μm to 4 μm has a peak consistent with distribution of the Pulse function, and these particles have a particle size $D_{50}$ of about 2.0 μm. Gaps will be caused by accumulation of the particles with the particle size ranging from 1 μm to 4 μm, and the particles with the particle size ranging from 0.1 μm to 1 μm and excluding 1 μm are filled into the gaps of the particles with the particle size ranging from 1 μm to 4 μm, such that the porosity of the cathode material is further reduced, the compaction density of an electrode plate is effectively improved, infiltration in the electrolyte is more uniform, and the material can achieve higher capacity and rate performance.

As shown in Fig. 2, in the two peaks of the cathode material, the first peak is long and narrow and has a peak value of greater than 15%, and the second peak is short and wide and has a peak value of less than 10%.

Embodiment **2**

Different from Embodiment 1,

(1) appropriate amounts of nickel chloride, cobalt chloride and manganese chloride were weighed, a precursor $Ni_{0.6}Co_{0.1}Mn_{0.3}O$ was obtained by a spray pyrolysis method, and a pressure-diameter ratio of a nozzle was controlled at 20 MPa/mm.

Embodiment 3

Different from Embodiment 1,

(1) appropriate amounts of nickel chloride, cobalt chloride and manganese chloride were weighed, a precursor

$Ni_{0.6}Co_{0.1}Mn_{0.3}O$ was obtained by a spray pyrolysis method, and a pressure-diameter ratio of a nozzle was controlled at 40 MPa/mm.

Embodiment **4**

Different from Embodiment 1,

(2) 1 kg of a precursor and 503.6 g of lithium carbonate were weighed, evenly mixed and then subjected to primary sintering treatment at 1,000 °C for 8 h in an oxygen atmosphere to obtain a primary sintering product.

Embodiment **5**

(1) Appropriate amounts of nickel chloride, cobalt chloride and manganese chloride were weighed, a precursor $Ni_{0.94}Co_{0.035}Mn_{0.25}O$ was obtained by a spray pyrolysis method, and a pressure-diameter ratio of a nozzle was controlled at 40 MPa/mm.

(2) 1 kg of the precursor and 503.6 g of lithium carbonate were weighed, evenly mixed and then subjected to primary sintering treatment at 680 °C for 8 h in an oxygen atmosphere to obtain a primary sintering product.

(3) After the above material was fully dispersed by a stirrer, 200 g of the primary sintering product and 2 g of boric acid were mixed, transferred to an atmosphere furnace and subjected to heat treatment at 550 °C for 5 h. Then, a final product $LiNi_{0.94}Co_{0.035}Mn_{0.025}O_2$ was obtained.

Embodiment 6

(1) Appropriate amounts of nickel chloride, cobalt chloride and manganese chloride were weighed, a precursor $Ni_{0.825}Co_{0.065}Mn_{0.11}O$ was obtained by a spray pyrolysis method, and a pressure-diameter ratio of a nozzle was controlled at 15 MPa/mm.

(2) 1 kg of the precursor and 503.6 g of lithium carbonate were weighed, evenly mixed and then subjected to primary sintering treatment at 850 °C for 8 h in an oxygen atmosphere to obtain a cathode material.

Embodiment **7**

(1) Appropriate amounts of nickel chloride, cobalt chloride and manganese chloride were weighed, a precursor $Ni_{0.6}Co_{0.1}Mn_{0.3}O$ was obtained by a spray pyrolysis method, and a pressure-diameter ratio of a nozzle was controlled at 30 MPa/mm.

(2) 1 kg of the precursor and 503.6 g of lithium carbonate were weighed, evenly mixed and then subjected to primary sintering treatment at 950 °C for 8 h in an oxygen atmosphere to obtain a primary sintering product.

(3) 300 g of the primary sintering product and 10 g of cobalt oxide were weighed, evenly mixed, subjected to secondary sintering treatment at 800 °C for 5 h in an atmosphere furnace and then cooled to room temperature to obtain a secondary sintering product.

(4) After the above material was fully dispersed by a stirrer, 200 g of the secondary sintering product and 2 g of boric acid were mixed, transferred to an atmosphere furnace and subjected to heat treatment at 550 °C for 5 h. Then, a final product $LiNi_{0.6}Co_{0.1}Mn_{0.3}O_2$ was obtained.

Embodiment 8

(1) Appropriate amounts of nickel chloride, cobalt chloride and manganese chloride were weighed, a precursor $Ni_{0.6}C0_{0.1}Mn_{0.3}O$ was obtained by a spray pyrolysis method, and a pressure-diameter ratio of a nozzle was controlled at 10 MPa/mm.

(2) 1 kg of the precursor and 503.6 g of lithium carbonate were weighed, evenly mixed and then subjected to primary sintering treatment at 890 °C for 8 h in an oxygen atmosphere to obtain a primary sintering product.

(3) 300 g of the primary sintering product and 10 g of cobalt oxide were weighed, evenly mixed, subjected to secondary sintering treatment at 800 °C for 5 h in an atmosphere furnace and then cooled to room temperature to obtain a secondary sintering product.

(4) After the above material was fully dispersed by a stirrer, 200 g of the secondary sintering product and 2 g of boric acid were mixed, transferred to an atmosphere furnace and subjected to heat treatment at 550 °C for 5 h. Then, a final product $LiNi_{0.6}Co_{0.1}Mn_{0.3}O_2$ was obtained.

Embodiment **9**

Different from Embodiment 8,

(5) 50 g of a monocrystalline cathode material $LiNi_{0.6}Co_{0.1}Mn_{0.3}O_2$ with a Span value of 1.2 and a $D_{50}$ value of 5.1 $\mu$m was added to the final product $LiNi_{0.6}Co_{0.1}Mn_{0.3}O_2$.

Embodiment 10

(1) 500 g of a conventional monocrystalline cathode material $Ni_{0.6}Co_{0.1}Mn_{0.3}O$ with a Span (a) value of 1.2 and a $D_{50}$ value of 3.8 $\mu$m that was prepared by a coprecipitation method was selected.

(2) 100 g of a powdery monocrystalline cathode material $LiNi_{0.6}Co_{0.1}Mn_{0.3}O_2$ with a Span (b) value of 0.5 and a $D_{50}$ value of 0.8 $\mu$m was selected.

(3) The cathode materials in steps (1) and (2) were evenly mixed to obtain a cathode material.

Comparative Embodiment 1

(1) Appropriate amounts of nickel chloride, cobalt chloride and manganese chloride were weighed, a precursor $Ni_{0.925}CO_{0.045}Mn_{0.03}O$ was obtained by a spray pyrolysis method, and a pressure-diameter ratio of a nozzle was controlled at 45 MPa/mm.

(2) 1 kg of the precursor and 503.6 g of lithium carbonate were weighed, evenly mixed and then subjected to primary sintering treatment at 750 °C for 8 h in an oxygen atmosphere to obtain a primary sintering product.

(3) 300 g of the primary sintering product and 10 g of zirconia were weighed, evenly mixed, subjected to secondary sintering treatment at 600 °C for 5 h in an atmosphere furnace and then cooled to room temperature to obtain a secondary sintering product.

(4) After the above material was fully dispersed by a stirrer, 200 g of the secondary sintering product and 2 g of boric acid were mixed, transferred to an atmosphere furnace and subjected to heat treatment at 550 °C for 5 h. Then, a final product $LiNi_{0.92}sCo_{0.035}Mn_{0.03}Zr_{0.01}O_2$ was obtained.

Comparative Embodiment 2

(1) Appropriate amounts of nickel chloride, cobalt chloride and manganese chloride were weighed, a precursor

$Ni_{0.925}Co_{0.045}Mn_{0.03}O$ was obtained by a spray pyrolysis method, and a pressure-diameter ratio of a nozzle was controlled at 3 MPa/mm.

(2) 1 kg of the precursor and 503.6 g of lithium carbonate were weighed, evenly mixed and then subjected to primary sintering treatment at 730 °C for 8 h in an oxygen atmosphere to obtain a primary sintering product.

(3) 300 g of the primary sintering product and 10 g of zirconia were weighed, evenly mixed, subjected to secondary sintering treatment at 800 °C for 5 h in an atmosphere furnace and then cooled to room temperature to obtain a secondary sintering product.

(4) After the above material was fully dispersed by a stirrer, 200 g of the secondary sintering product and 2 g of boric acid were mixed, transferred to an atmosphere furnace and subjected to heat treatment at 550 °C for 5 h. Then, a final product $LiNi_{0.925}Co_{0.035}Mn_{0.03}Zr_{0.0}O_2$ was obtained.

Comparative Embodiment 3

(1) 1 kg of a monocrystalline ternary precursor $Ni_{0.60}Co_{0.10}Mn_{0.30}O$ prepared by a coprecipitation method and 503.6 g of lithium carbonate were weighed, evenly mixed and then subjected to primary sintering treatment at 900 °C for 10 h in an oxygen atmosphere to obtain a primary sintering product.

(2) 300 g of the primary sintering product and 10 g of cobalt oxide were weighed, evenly mixed, subjected to secondary sintering treatment at 800 °C for 5 h in an atmosphere furnace and then cooled to room temperature to obtain a secondary sintering product.

(3) After the above active substance was fully dispersed by a stirrer, 200 g of the secondary sintering product and 2 g of boric acid were mixed, transferred to an atmosphere furnace and subjected to heat treatment at 550 °C for 5 h to obtain a cathode material.

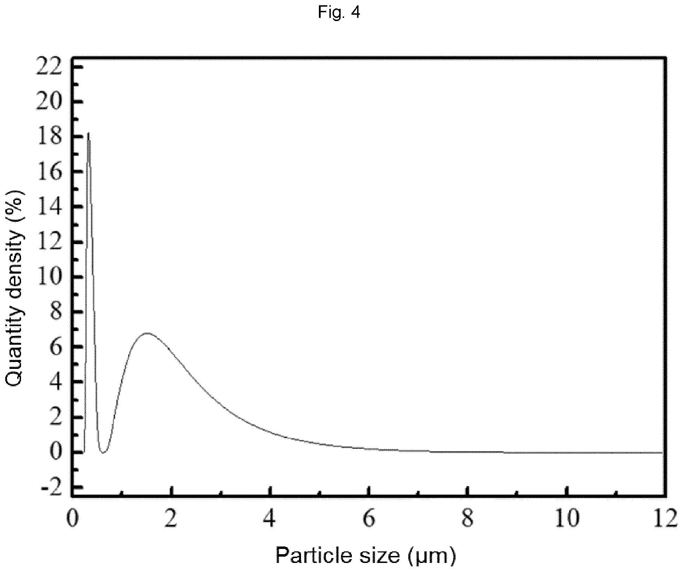

Fig. 4 shows a particle size distribution curve of a cathode material prepared in Comparative Embodiment 1. The curve has only one peak, which is consistent with a typical normal distribution law, is applicable to the Pulse function and has only one peak.

Comparative Embodiment 4

(1) 1 kg of a polycrystalline cathode material $LiNi_{0.6}Co_{0.1}Mn_{0.3}O_2$ with a particle size of 12 $\mu$m was weighed.

(2) 300 g of a polycrystalline cathode material $LiNi_{0.6}Co_{0.1}Mn_{0.3}O_2$ with a particle size of 6.5 $\mu$m was weighed.

(3) The above materials were evenly mixed by a stirrer to obtain a cathode material.

Comparative Embodiment 5

(1) 1 kg of a ternary precursor $Ni_{0.6}Co_{0.1}Mn_{0.3}O$ prepared by a coprecipitation method and 503.6 g of lithium carbonate were weighed, evenly mixed and then subjected to primary sintering treatment at 880 °C for 10 h in an oxygen atmosphere to obtain a primary sintering product.

(2) 300 g of the primary sintering product and 10 g of cobalt oxide were weighed, evenly mixed, subjected to secondary sintering treatment at 800 °C for 5 h in an atmosphere furnace and then cooled to room temperature to obtain a secondary sintering product.

(3) After the secondary sintering product was fully dispersed by a stirrer, 200 g of the secondary sintering product and 2 g of boric acid were mixed, transferred to an atmosphere furnace and subjected to heat treatment at 550 °C for 5 h to obtain a cathode material $LiNi_{0.6}CO_{0.15}Mn_{0.3}O_2$.

(4) The cathode material $LiNi_{0.6}Co_{0.1}Mn_{0.3}O_2$ and 1 kg of a polycrystalline cathode material $LiNi_{0.6}Co_{0.1}Mn_{0.3}O_2$ with a $D_{50}$ value of 12 $\mu$m were evenly mixed to finally obtain a cathode material.

Table 1 Comparison table of properties and parameters of cathode materials in embodiments and comparative embodiments

| Serial number | $D_{50}$ of particles ranging from 1 $\mu$m to 4 $\mu$m | Span (a) | $D_{50}$ of particles ranging from 0.1 $\mu$m to 1 $\mu$m | Span (b) | $D_{10}$ | $D_{90}$ | $D_{50}$ | Peak value of a distribution curve of particles ranging from 0.1 $\mu$m to 1 $\mu$m | Whether single grains with a same one ntation are contained | Average particle size ($\mu$m) of single grains with a same orientation |
|---|---|---|---|---|---|---|---|---|---|---|
| Embodiment 1 | 3.98 | 1.18 | 0.98 | 0.43 | 1.78 | 6.30 | 3.52 | 18% | Yes | 2.43 |
| Embodiment 2 | 2.80 | 1.32 | 0.13 | 0.48 | 1.10 | 6.19 | 3.69 | 19% | Yes | 2.94 |
| Embodiment 3 | 3.81 | 1.44 | 0.56 | 0.63 | 1.36 | 6.45 | 3.99 | 17% | Yes | 3.13 |
| Embodiment 4 | 3.96 | 1.54 | 0.33 | 0.69 | 1.44 | 7.15 | 3.38 | 16% | Yes | 2.89 |
| Embodiment 5 | 1.63 | 1.29 | 0.28 | 0.58 | 1.38 | 5.79 | 3.38 | 18% | Yes | 1.98 |
| Embodiment 6 | 2.40 | 1.23 | 0.25 | 0.55 | 1.45 | 5.70 | 3.37 | 17% | Yes | 2.65 |
| Embodiment 7 | 2.33 | 1.22 | 0.55 | 0.41 | 1.74 | 6.98 | 3.13 | 17% | Yes | 2.70 |
| Embodiment 8 | 2.44 | 1.31 | 0.21 | 0.50 | 1.36 | 6.04 | 3.26 | 18% | Yes | 2.22 |
| Embodiment 9 | 3.50 | 1.40 | 0.27 | 0.60 | 1.46 | 5.67 | 2.92 | 18% | Yes | 1.22 |
| Embodiment 10 | 2.97 | 1.35 | 0.26 | 0.41 | 1.46 | 5.59 | 3.20 | 20% | Yes | 2.01 |
| Comparative Embodiment 1 | 2.52 | 1.19 | 0.50 | 0.35 | 1.66 | 5.68 | 3.57 | 17% | Yes | 2.57 |
| Comparative Embodiment 2 | 1.80 | 0.79 | 0.55 | 0.02 | 1.67 | 6.34 | 3.76 | 17% | Yes | 3.45 |
| Comparative Embodiment 3 | 3.65 | 1.20 | None | None | 2.10 | 5.67 | 3.51 | None | Yes | 3.66 |
| Comparative Embodiment 4 | 13.10 | 0.25 | 6.50 | 0.39 | 6.20 | 20.01 | 13.87 | 21% | No | 5.11 |

(continued)

| Serial number | D$_{50}$ of particles ranging from 1 μm to 4 μm | Span (a) | D$_{50}$ of particles ranging from 0.1 μm to 1 μm | Span (b) | D$_{10}$ | D$_{90}$ | D$_{50}$ | Peak value of a distribution curve of particles ranging from 0.1 μm to 1 μm | Whether single grains with a same one orientation are contained | Average particle size (μm) of single grains with a same orientation |
|---|---|---|---|---|---|---|---|---|---|---|
| Comparative Embodiment 5 | 12.20 | 0.66 | 1.23 | 0.98 | 4.54 | 20.23 | 12.23 | 2% | No | 6.23 |

Table 2 Comparison table of cathode plates in embodiments and comparative embodiments

| Serial number | Quant achrome tap density | Compaction density | Bulk density | First cycle capacity /mAh/g | Initial efficiency % | Cycle retention rate % | Capacity retention rate % |
|---|---|---|---|---|---|---|---|
| Embodiment 1 | 2.02 | 3.24 | 1.20 | 197.1 | 89.8 | 97.0 | 95.8 |
| Embodiment 2 | 2.26 | 3.32 | 1.35 | 197.5 | 90.1 | 96.8 | 95.4 |
| Embodiment 3 | 2.47 | 3.45 | 1.37 | 198.6 | 90.5 | 96.9 | 95.4 |
| Embodiment 4 | 2.64 | 3.53 | 1.47 | 198.8 | 90.6 | 97.1 | 95.9 |
| Embodiment 5 | 2.21 | 3.34 | 1.31 | 227.2 | 92.3 | 95.3 | 93.0 |
| Embodiment 6 | 2.11 | 3.28 | 1.25 | 207.1 | 91.0 | 94.7 | 92.9 |
| Embodiment 7 | 2.09 | 3.35 | 1.24 | 197.8 | 90.0 | 97.3 | 96.0 |
| Embodiment 8 | 2.24 | 3.40 | 1.33 | 198.0 | 90.2 | 97.8 | 95.0 |
| Embodiment 9 | 2.40 | 3.34 | 1.43 | 198.3 | 89.9 | 96.9 | 95.1 |
| Embodiment 10 | 2.31 | 3.41 | 1.38 | 196.9 | 89.5 | 96.8 | 95.5 |
| Comparative Embodiment 1 | 2.04 | 3.22 | 1.21 | 220.0 | 91.5 | 93.9 | 91.8 |
| Comparative Embodiment 2 | 1.84 | 3.21 | 1.29 | 219.9 | 91.5 | 94.0 | 91.7 |
| Comparative Embodiment 3 | 2.05 | 3.19 | 1.22 | 192.4 | 88.7 | 94.3 | 91.0 |
| Comparative Embodiment 4 | 1.43 | 2.99 | 0.85 | 196.1 | 90.1 | 94.8 | 91.4 |
| Comparative Embodiment 5 | 1.73 | 2.77 | 1.03 | 191.2 | 87.4 | 95.2 | 90.6 |

As can be seen from data in Table 1 and Table 2, by controlling the particle size distribution width of the particles with the particle size ranging from 1 μm to 4 μm as Span (a) and the particle size distribution width of the particles with the particle size ranging from 0.1 μm to 1 μm and excluding 1 μm as Span (b), the compaction density of the material can be effectively improved, and the packing density of the particles is increased. Since distribution curves of the two particles are consistent with different distribution morphology of a Pulse function and distribution morphology of a Voigt function, a closest packing mode of a monodisperse system can be achieved, and that is to say, multistage dispersed mixing of the particles is achieved to improve the packing density.

Through parameter adjustment of the raw materials and the aperture ratio of the nozzle in Comparative Embodiment 1, a Span (b) value of the D$_{50}$ of the particles ranging from 0.1 μm to 1 μm in the final cathode material is out of range, so that the packing density of the particles of the cathode material is affected. Moreover, since the content of Ni is greatly increased, the initial coulombic efficiency of the material is improved. However, in a cyclic charging and discharging process, the capacity is seriously decreased, and accordingly, the capacity retention rate is decreased.

Through parameter adjustment of the raw materials and the aperture ratio of the nozzle in Comparative Embodiment 2, a Span (b) value of the $D_{50}$ of the particles ranging from 1 $\mu$m to 4 $\mu$m in the final cathode material is out of range, so that the packing density of the particles of the cathode material is affected. Moreover, since the content of Ni is greatly increased, the initial coulombic efficiency of the material is improved. However, in a cyclic charging and discharging process, the capacity is seriously decreased, and accordingly, the capacity retention rate is decreased.

According to a particle size distribution curve of the cathode material prepared in Comparative Embodiment 3, the curve has only one peak that is in line with a typical normal distribution law and is consistent with distribution of the Pulse function, the cathode material has low contents of small particles and large particles and too many medium particles, and the small particles are not sufficient enough to be inserted into gaps of the large particles to further improve the packing density, so that the cathode material has difficulty in achieving high packing density, and accordingly, the Quantachrome tap density, compaction density and bulk density of the cathode material are low.

The cathode material prepared in Comparative Embodiment 4 is a polycrystalline material, which has two-peak distribution characteristics by mixing large and small particles and has two peaks. However, in a particle size quantity distribution diagram of the cathode material, the peak in the particle size ranging from 0.1 $\mu$m to 1 $\mu$m and excluding 1 $\mu$m is not consistent with the Voigt function, and numerical ranges of Span (b) and Span (a) are out of appropriate ranges. The particles have poor stability, cracking of the particles is increased in a pressing process of an electrode plate, the compaction density of the electrode plate is decreased, and the cycle capacity retention rate is also decreased.

According to the cathode material prepared in Comparative Embodiment 5, values of span (a) and span (b) are not within the scopes of the present disclosure, and particles are generally large and have difficulty in achieving effective compaction and accumulation, so that various densities of the cathode material are obviously decreased, and the initial efficiency, cycle retention rate and capacity retention rate of the material are also obviously decreased.

The description above shows only preferred embodiments of the present disclosure and is not intended to limit the present disclosure. For persons skilled in the art, various alterations and changes of the present disclosure may be made. Any modifications, equivalent substitutions, improvements and the like made within the spirit and principles of the present disclosure shall be included in the scope of protection of the present disclosure.

**Claims**

1. A cathode material, wherein the cathode material has a chemical formula of $Li_aNi_xM_yN_zO_2$, $0.98 \le a \le 1.05$, $0.60 \le x < 1$, $0 < y \le 0.40$, $0.5z < 0.1$, $x+y+z=1$, M is selected from at least one of Co, Mn and Al, and N is a doping metal;

   in a particle size quantity distribution diagram of the cathode material, a distribution curve of particles with a particle size ranging from 1 $\mu$m to 4 $\mu$m has a peak consistent with distribution of a Pulse function, and a particle size distribution width of the particles with the particle size ranging from 1 $\mu$m to 4 $\mu$m is Span (a) and satisfies that 0.8<Span (a) <1.6;
   and in the particle size quantity distribution diagram of the cathode material, a distribution curve of particles with a particle size ranging from 0.1 $\mu$m to 1 $\mu$m and excluding 1 $\mu$m has a peak consistent with distribution of a Voigt function, and a particle size distribution width of the particles with the particle size ranging from 0.1 $\mu$m to 1 $\mu$m and excluding 1 $\mu$m is Span (b) and satisfies that 0.4<Span (b) <0.8.

2. The cathode material according to claim 1, wherein the cathode material comprises single grains with a same orientation, and an average particle size of the single grains is 1 $\mu$m-5 $\mu$m.

3. The cathode material according to claim 2, wherein a mass content of the element N in the cathode material is 500 ppm-10,000 ppm; and/or, the N is selected from at least one of Ti, Zr, Mg, Ca, Sr, Ba, Nb, Ta, Sb, Sn, Wand Y.

4. The cathode material according to claim 1, wherein in the cathode material, the particles ranging from 1 $\mu$m to 4 $\mu$m satisfy that 1 $\mu$m$\le D_{50} \le$4 $\mu$m.

5. The cathode material according to claim 1, wherein in the cathode material, the particles ranging from 0.1 $\mu$m to 1 $\mu$m satisfy that 0.1 $\mu$m$\le D_{50} \le$1 $\mu$m.

6. The cathode material according to claim 1, wherein in the cathode material, the distribution curve of the particles ranging from 0.1 $\mu$m to 1 $\mu$m has a peak value of equal to or greater than 15%.

7. The cathode material according to claim 1, wherein the cathode material satisfies at least one of the following technical features:

(1) particle size volume distribution of the cathode material satisfies that $D_{min}>0.1$ $\mu$m, 2.5 $\mu$m$<D_{50}<5.5$ $\mu$m and $D_{max}<14$ $\mu$m;

(2) a particle size volume distribution width of the cathode material satisfies that 1.2 $\mu$m$\leq(D_{90}-D_{10})/D_{50}$, $D_{10}\leq1.8$ $\mu$m and $D_{90}\geq5.5$ $\mu$m; and

(3) in the particle size quantity distribution diagram of the cathode material, the cathode material has at least two particle size distribution peaks.

8. The cathode material according to any one of claims 1-7, wherein in an X-ray diffraction (XRD) pattern of the cathode material, a characteristic peak corresponding to a crystal face (003) has a peak intensity of $I_{003}$, a characteristic peak corresponding to a crystal face (104) of the cathode material has a peak intensity of $I_{104}$, and $I_{003}/I_{104}$ is 1.2-1.6.

9. The cathode material according to any one of claims 1-7, wherein the cathode material has a specific surface area of 0.6 m$^2$/g-1.5 m$^2$/g.

10. The cathode material according to any one of claims 1-7, wherein the cathode material satisfies at least one of the following technical features:

   (1) the cathode material has a Quantachrome tap density of equal to or greater than 1.8 g/cm$^3$;

   (2) the cathode material has a compaction density of equal to or greater than 3.2 g/cm$^3$; and

   (3) the cathode material has a bulk density of equal to or greater than 1.2 g/cm$^3$.

11. A preparation method for a cathode material, comprising the following steps:

   subjecting a mixed salt solution to spray drying by a spray pyrolysis method to obtain a precursor, wherein the mixed salt solution comprises a nickel source and an M source, a pressure-diameter ratio of a nozzle is controlled at 3.5 MPa/mm-40 MPa/mm in a spray drying process, and the M is selected from at least one of Co, Mn and Al; and subjecting a mixture of the precursor and a lithium source to primary sintering treatment to obtain a cathode material.

12. The preparation method according to claim 11, wherein the preparation method satisfies at least one of the following technical features:

   (1) the precursor has a chemical formula of Ni$_x$M$_y$O, wherein 0.60$\leq$x$<$1 and 0$<$y$\leq$0.40;

   (2) the nickel source comprises at least one of nickel nitrate, nickel acetate, nickel chloride and nickel sulfate;

   (3) the M source comprises at least one of M nitrate, M acetate, M chloride and M sulfate;

   (4) an internal temperature of a reaction chamber is 550 °C-1,050 °C in the spray drying process; and

   (5) the mixed salt solution has a concentration of 0.5 mol/L-4 mol/L.

13. The preparation method according to claim 11, wherein the preparation method satisfies at least one of the following technical features:

   (1) the lithium source comprises at least one of lithium hydroxide, lithium carbonate, lithium nitrate, lithium acetate, lithium sulfate and lithium oxalate;

   (2) addition amounts of the lithium source and the precursor satisfy that a ratio of a molar amount of Li to a total molar amount of metals in the precursor is (1.01-1.1):1; and

   (3) the primary sintering treatment is carried out at a temperature of 600 °C-1,000 °C, and the primary sintering treatment is carried out for 6 h-16 h.

14. The preparation method according to claim 11, wherein the method further comprises: mixing a primary sintering product with a dopant containing a metal N, and carrying out secondary sintering treatment to obtain a secondary sintering product, wherein the secondary sintering treatment is carried out at a temperature of 60°C-1,000 °C, the secondary sintering treatment is carried out for 6 h-16 h, and/or, the N is selected from at least one of Ti, Zr, Mg, Ca, Sr, Ba, Nb, Ta, Sb, Sn, W and Y.

15. The preparation method according to claim 14, wherein the method further comprises: carrying out a reaction between the primary sintering product or the secondary sintering product and boric acid to obtain a cathode material; and calculated with a mass of the cathode material as 100%, an addition amount of the boric acid is 500 ppm-2,000 ppm.

16. A battery, wherein the battery comprises the cathode material according to any one of claims 1-10 or the cathode material prepared by the preparation method for a cathode material according to any one of claims 11-15.

Fig. 1

subject a mixed salt solution to spray drying by a spray pyrolysis method to obtain a precursor, where the mixed salt solution includes a nickel source and an M source, a pressure-diameter ratio of a nozzle is controlled at 3.5 MPa/mm-40 MPa/mm in a spray drying process, and M is selected from at least one of Co, Mn and Al ⌐S10

↓

subject a mixture of the precursor and a lithium source to primary sintering treatment to obtain a cathode material ⌐S20

Fig. 2

Fig. 3

Fig. 4

Fig. 5

Fig. 6

**EP 4 553 926 A1**

| INTERNATIONAL SEARCH REPORT | International application No. |
|---|---|
| | **PCT/CN2024/090293** |

**A. CLASSIFICATION OF SUBJECT MATTER**

H01M4/505(2010.01)i;  H01M4/04(2006.01)i;  H01M10/0525(2010.01)i

According to International Patent Classification (IPC) or to both national classification and IPC

**B. FIELDS SEARCHED**

Minimum documentation searched (classification system followed by classification symbols)

IPC:H01M4/-; H01M10/-

Documentation searched other than minimum documentation to the extent that such documents are included in the fields searched

Electronic data base consulted during the international search (name of data base and, where practicable, search terms used)

CNTXT, ENTXTC, DWPI, CNKI, STN, ISI_Web of Science: 锂, 电池, 正极材料, 粒径, 函数, 峰, 分布, 宽度, 喷雾, 喷嘴, 压力, 直径, battery, anode, particle, size, function, Pulse, Voigt, Span, distribution, width, nozzle, pressure, diameter

**C. DOCUMENTS CONSIDERED TO BE RELEVANT**

| Category* | Citation of document, with indication, where appropriate, of the relevant passages | Relevant to claim No. |
|---|---|---|
| PX | CN 117293308 A (SHENZHEN BTR NANOMETER TECHNOLOGY CO., LTD.) 26 December 2023 (2023-12-26)<br>description, paragraphs [0123]-[0160], and figures 2-4 | 1-16 |
| A | CN 110050368 A (SUMITOMO CHEMICAL CO., LTD. et al.) 23 July 2019 (2019-07-23)<br>description, paragraphs [0235]-[0246] and [0270]-[0289] | 1-16 |
| A | CN 102790213 A (ELECTRIC POWER RESEARCH INSTITUTE OF GUANGDONG POWER GRID CORP.) 21 November 2012 (2012-11-21)<br>entire description | 1-16 |
| A | CN 110036512 A (SUMITOMO CHEMICAL CO., LTD. et al.) 19 July 2019 (2019-07-19)<br>entire description | 1-16 |
| A | CN 113224271 A (NINGDE AMPEREX TECHNOLOGY LTD.) 06 August 2021 (2021-08-06)<br>entire description | 1-16 |
| A | CN 114600282 A (PANASONIC INTELLECTUAL PROPERTY MANAGEMENT CO., LTD.) 07 June 2022 (2022-06-07)<br>entire description | 1-16 |

☑ Further documents are listed in the continuation of Box C.  ☑ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **26 June 2024** | **03 July 2024** |

| Name and mailing address of the ISA/CN | Authorized officer |
|---|---|
| **China National Intellectual Property Administration (ISA/ CN)**<br>**China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

International application No.

**PCT/CN2024/090293**

C.    DOCUMENTS CONSIDERED TO BE RELEVANT

| Category* | Citation of document, with indication, where appropriate, of the relevant passages | Relevant to claim No. |
|---|---|---|
| A | JP 2018041657 A (GS YUASA CORP.) 15 March 2018 (2018-03-15)<br>entire description | 1-16 |

Form PCT/ISA/210 (second sheet) (July 2022)

27

**INTERNATIONAL SEARCH REPORT**
**Information on patent family members**

International application No.

**PCT/CN2024/090293**

| Patent document cited in search report | | | Publication date (day/month/year) | Patent family member(s) | | | Publication date (day/month/year) |
|---|---|---|---|---|---|---|---|
| CN | 117293308 | A | 26 December 2023 | None | | | |
| CN | 110050368 | A | 23 July 2019 | US | 2021043917 | A1 | 11 February 2021 |
| | | | | US | 11011741 | B2 | 18 May 2021 |
| | | | | EP | 3553856 | A1 | 16 October 2019 |
| | | | | EP | 3553856 | A4 | 05 August 2020 |
| | | | | EP | 3553856 | B1 | 21 February 2024 |
| | | | | KR | 20190085521 | A | 18 July 2019 |
| | | | | KR | 102367509 | B1 | 25 February 2022 |
| | | | | WO | 2018105490 | A1 | 14 June 2018 |
| | | | | JP | 2018098218 | A | 21 June 2018 |
| | | | | JP | 6343753 | B2 | 20 June 2018 |
| | | | | JP | 2018098183 | A | 21 June 2018 |
| CN | 102790213 | A | 21 November 2012 | None | | | |
| CN | 110036512 | A | 19 July 2019 | JPWO | 2018105481 | A1 | 24 October 2019 |
| | | | | JP | 7002469 | B2 | 20 January 2022 |
| | | | | WO | 2018105481 | A1 | 14 June 2018 |
| | | | | KR | 20190086692 | A | 23 July 2019 |
| | | | | KR | 102413743 | B1 | 27 June 2022 |
| CN | 113224271 | A | 06 August 2021 | None | | | |
| CN | 114600282 | A | 07 June 2022 | EP | 4053080 | A1 | 07 September 2022 |
| | | | | EP | 4053080 | A4 | 28 December 2022 |
| | | | | US | 2022376244 | A1 | 24 November 2022 |
| | | | | JPWO | 2021085112 | A1 | 06 May 2021 |
| | | | | WO | 2021085112 | A1 | 06 May 2021 |
| JP | 2018041657 | A | 15 March 2018 | JP | 6844156 | B2 | 17 March 2021 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202311290065X

- GB 190772016 T